# EUROPÄISCHE PATENTSCHRIFT

(11) **EP 0 991 192 B1**
(45) Veröffentlichungstag und Bekanntmachung des Hinweises auf die Patenterteilung: **03.09.2003**
(21) Anmeldenummer: 99117723.9
(22) Anmeldetag: 08.09.1999
(51) Int. Cl.: H03L 7/081

(54) **Integrierte Schaltung mit einstellbaren Verzögerungseinheiten für Taktsignale**
Integrated circuit with adjustable delay units for clock signals
Circuit intégré comprenant des éléments de retard ajustables pour signaux d'horloge

(30) Priorität: 30.09.1998 DE 19845121
(43) Veröffentlichungstag der Anmeldung: 05.04.2000
(73) Patentinhaber: Infineon Technologies AG, 81669 München (DE)
(72) Erfinder: Heyne, Patrick, 81541 München (DE)
(74) Vertreter: Fischer, Volker, Dipl.-Ing.

(56) Entgegenhaltungen:
- WO-A-98/35446
- DE-A- 19 703 986
- US-A- 5 684 421

## Beschreibung

Die Erfindung betrifft eine integrierte Schaltung mit einstellbaren Verzögerungseinheiten für Taktsignale.

In der US 5,684,421 A ist eine Delay Locked Loop (DLL) beschrieben, die aus einem Eingangstakt einen zeitverzögerten Ausgangstakt erzeugt, der gegenüber dem Eingangstakt eine bestimmte Phasenbeziehung aufweist. Zwischen dem Eingang und dem Ausgang der DLL ist eine einstellbare Verzögerungseinheit angeordnet. Der Eingang und der Ausgang sind außerdem mit einem Phasendetektor verbunden, der in Abhängigkeit der festgestellten Phasendifferenz die Verzögerungszeit der Verzögerungseinheit steuert. Es ist auch beschrieben, daß zwischen dem Ausgang der DLL und/oder dem Eingang der DLL und dem Phasendetektor jeweils eine weitere einstellbare Verzögerungseinheit vorgesehen sein kann. Diese weiteren einstellbaren Verzögerungseinheiten dienen der Einstellung der Phasenlage des Ausgangstakts gegenüber dem Eingangstakt. Der Phasendetektor ermittelt immer die Phasendifferenz zwischen den ihm direkt zugeführten Taktsignalen.

Der US 5,684,421 A ist auch eine DLL zu entnehmen, deren Eingangstakt ein differenzielles Taktsignal ist, das der Verzögerungseinheit über ein Leitungspaar zugeführt wird. Die Signale auf beiden Leitungen des Leitungspaars werden gleichmäßig durch die Verzögerungseinheit verzögert. Somit werden die Signale auf beiden Leitungen des Datenleitungspaares mit derselben Verzögerungszeit verzögert und der DLL nachgeschalteten Schaltungskomponenten zugeführt.

In WO 98/35446 ist ein Taktgenerator mit einer DLL-Schaltung gezeigt. Eine Schaltung zur Takterzeugung weist einen ersten Signalpfad und einen zweiten Signalpfad mit je einem steuerbaren Verzögerungsglied auf. Ein erster Eingang eines Phasendetektors ist mit dem ersten Signalpfad verbunden, ein zweiter Eingang des Phasendetektors ist mit dem Ausgang des ersten Verzögerungsglieds verbunden. Die Verzögerung des zweiten Verzögerungsglieds ist im wesentlichen gleich zu der Verzögerung des ersten Verzögerungsglieds einstellbar.

Der Erfindung liegt die Aufgabe zugrunde, eine integrierte Schaltung anzugeben, bei der eine Verzögerung zweier Eingangstakte erfolgt, so daß die erzeugten Ausgangstakte eine bestimmte Phasendifferenz zum jeweiligen Eingangstakt aufweisen, die mit geringem Aufwand realisiert ist und bei der die Ausgangstakte jeweils unterschiedliche Verzögerungen gegenüber ihren Eingangstakten aufweisen können.

Diese Aufgabe wird mit einer integrierten Schaltung gemäß Patentanspruch 1 gelöst. Vorteilhafte Aus- und Weiterbildungen sind Gegenstand abhängiger Ansprüche.

Die erfindungsgemäße integrierte Schaltung weist eine erste Verzögerungseinheit mit einstellbarer Verzögerungszeit auf, die einen Eingang zur Zuführung eines ersten Taktsignals aufweist, sowie eine zweite Verzögerungseinheit mit einstellbarer Verzögerungszeit, die einen Eingang zur Zuführung eines zweiten Taktsignals aufweist. Weiterhin weist sie einen Phasendetektor auf, dessen erster Eingang mit dem Eingang und dessen zweiter Eingang mit dem Ausgang der ersten Verzögerungseinheit verbunden ist. Außerdem hat die integrierte Schaltung eine Steuereinheit, die zur Ausregelung der vom Phasendetektor festgestellten Phasendifferenz die Verzögerungszeit der ersten Verzögerungseinheit steuert und die außerdem die Verzögerungszeit der zweiten Verzögerungseinheit auf im wesentlichen den gleichen Wert wie diejenige der ersten Verzögerungseinheit einstellt. Die integrierte Schaltung weist eine Schaltungseinheit auf mit einem ersten Eingang, der mit dem Ausgang der ersten Verzögerungseinheit verbunden ist, und mit einem zweiten Eingang, der mit dem Ausgang der zweiten Verzögerungseinheit verbunden ist. Schließlich weist die integrierte Schaltung eine dritte Verzögerungseinheit mit einstellbarer Verzögerungszeit auf, über die der Ausgang der zweiten Verzögerungseinheit mit dem zweiten Eingang der Schaltungseinheit verbunden ist.

Die Einstellung der Verzögerungszeit der ersten und der zweiten Verzögerungseinheit erfolgt bei der Erfindung durch die Steuereinheit in Abhängigkeit von der vom Phasendetektor festgestellten Phasendifferenz. Die erste Verzögerungseinheit ist Bestandteil eines Regelkreises, der durch den Phasendetektor und die Steuereinheit geschlossen wird. Dagegen wird die Verzögerungszeit der zweiten Verzögerungseinheit lediglich von der Steuereinheit auf den gleichen Wert eingestellt, wie diejenige der ersten Verzögerungseinheit. Somit weist der Ausgangstakt am Ausgang der zweiten Verzögerungseinheit gegenüber deren Eingangstakt dieselbe zeitliche Verzögerung auf, wie der Ausgangstakt am Ausgang der ersten Verzögerungseinheit gegenüber deren Eingangstakt. Allerdings wird erfindungsgemäß der Ausgangstakt der zweiten Verzögerungseinheit nicht direkt der zu steuernden Schaltungseinheit zugeführt, sondern über die dritte Verzögerungseinheit. Da auch die Verzögerungszeit der dritten Verzögerungseinheit einstellbar ist, kann über diese eine gewünschte Phasenlage des der Schaltungseinheit zugeführten Ausgangstaktes der zweiten Verzögerungseinheit eingestellt werden, unabhängig von der Verzögerungszeit der ersten Verzögerungseinheit.

Die Erfindung wird im folgenden anhand der Figuren näher erläutert.
- Figur 1: zeigt ein erstes Ausführungsbeispiel der integrierten Schaltung,
- Figur 2: zeigt ein zweites Ausführungsbeispiel,
- Figur 3: zeigt ein drittes Ausführungsbeispiel der integrierten Schaltung,
- Figur 4: zeigt ein Ausführungsbeispiel einer Eingangsschaltung aus Figur 3 und
- Figur 5: zeigt ein Ausführungsbeispiel einer Schaltungseinheit aus Figur 3.

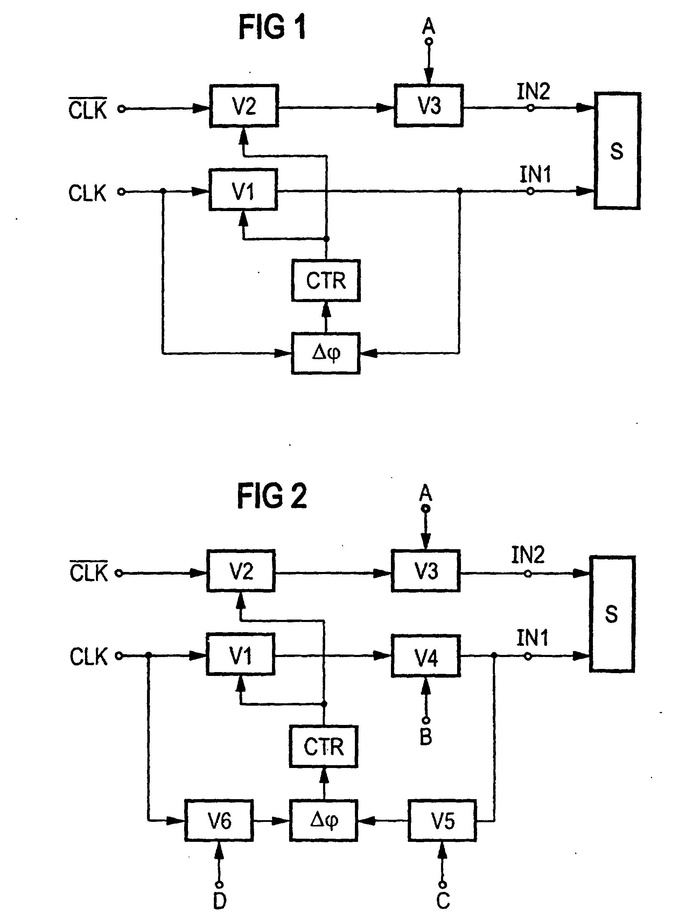

Figur 1 zeigt die zum Verständnis der Erfindung wesentlichen Komponenten einer integrierten Schaltung. Sie weist eine Schaltungseinheit S auf, die einen ersten Eingang IN1 und einen zweiten Eingang IN2 hat. An den Eingängen IN1, IN2 werden der Schaltungseinheit S Taktsignale zugeführt, die zu ihrer Ansteuerung dienen. Diese Taktsignale sind aus zwei Eingangstakten CLK, /CLK abgeleitet und weisen gegenüber diesen eine gewünschte Phasenlage auf. Zum Erzielen der gewünschten Phasenlage ist der erste Eingangstakt CLK über eine erste einstellbare Verzögerungseinheit V1 mit dem ersten Eingang IN1 der Schaltungseinheit S verbunden. Der Eingang und der Ausgang der ersten Verzögerungseinheit V1 sind mit einem Phasendetektor Δϕ verbunden, der eine gegebenenfalls vorhandene Phasendifferenz zwischen dem Ausgangstakt der ersten Verzögerungseinheit V1 und dem ersten Eingangstakt CLK detektiert. Ein Ausgang des Phasendetektor Δϕ ist mit einem Eingang einer Steuereinheit CTR verbunden, deren Ausgang mit einem Steuereingang der ersten Verzögerungseinheit V1 verbunden ist. Die Steuereinheit CTR stellt die Verzögerungszeit der ersten Verzögerungseinheit V1 aufgrund der vom Phasendetektor Δϕ ermittelten Phasendifferenz so ein, daß die Phasendifferenz zu Null wird. Die erste Verzögerungseinheit V1, der Phasendetektor Δϕ und die Steuereinheit CTR bilden einen Regelkreis einer Delay Locked Loop (DLL).

Der zweite Eingangstakt /CLK ist über eine einstellbare zweite Verzögerungseinheit V2 und eine einstellbare dritte Verzögerungseinheit V3 mit dem zweiten Eingang IN2 der Schaltungseinheit S verbunden. Die zweite Verzögerungseinheit V2 ist genauso aufgebaut wie die erste Verzögerungseinheit V1. Beide können beispielsweise wie die in der US 5,684 421 A beschriebenen einstellbaren Verzögerungseinheiten aufgebaut sein. Der Ausgang der Steuereinheit CTR ist auch mit einem Steuereingang der zweiten Verzögerungseinheit V2 verbunden. Daher stellt die Steuereinheit CTR die Verzögerungszeit der zweiten Verzögerungseinheit V2 auf denselben Wert ein wie diejenige der ersten Verzögerungseinheit V1.

Im vorliegenden Ausführungsbeispiel ist der zweite Eingangstakt /CLK der invertierte erste Eingangstakt CLK. Die Erfindung eignet sich vorteilhaft für Eingangstakte, die zueinander eine feste Phasenbeziehung aufweisen. Sie ist jedoch darauf nicht beschränkt und eignet sich daher auch für Eingangstakte, die keine feste Phasenbeziehung zueinander aufweisen. Bei anderen Ausführungsbeispielen der Erfindung kann der zweite Eingangstakt auch mit dem ersten Eingangstakt CLK übereinstimmen.

Da der zweite Eingangstakt /CLK invers zum ersten Eingangstakt CLK ist und die Verzögerungszeiten der ersten V1 und der zweiten V2 Verzögerungseinheit durch die Steuereinheit CTR immer auf den gleichen Wert eingestellt werden, weisen die Ausgangstakte der ersten und der zweiten Verzögerungseinheit bei diesem Ausführungsbeispiel zueinander ebenfalls die gleiche Phasenbeziehung wie die Eingangstakte CLK, /CLK auf. Es kann aber gewünscht sein, daß den Eingängen IN1, IN2 der Schaltungseinheit S Taktsignale zugeführt werden, deren Phasenbeziehung von der Phasenbeziehung der Eingangstakte CLK, /CLK abweicht. Um dies zu erreichen, weist die erfindungsgemäße integrierte Schaltung die dritte Verzögerungseinheit V3 auf, deren Verzögerungszeit unabhängig von der zweiten Verzögerungseinheit V2 einstellbar ist. Das Einstellen der Verzögerungszeit der dritten Verzögerungseinheit V3 erfolgt über einen Steuereingang A. Dies kann beispielsweise von außerhalb der integrierten Schaltung erfolgen oder durch Einstellen eines entsprechenden Steuersignals mittels programmierbarer Elemente, die Bestandteil der integrierten Schaltung sind. Hierzu eignen sich zum Beispiel mittels Laserstrahl auftrennbare elektrische Verbindungen (Laserfuses).

Die Verzögerungszeit der dritten Verzögerungseinheit V3 kann über ihren Steuereingang A zwischen Null und einem positiven Wert gewählt werden. Da bei diesem Ausführungsbeispiel der Ausgang der ersten Verzögerungseinheit V1 und ihr Eingang direkt mit dem Phasendetektor Δϕ verbunden sind, regelt die DLL das dem ersten Eingang IN1 der Schaltungseinheit S zugeführte Taktsignal so, daß es dieselbe Phasenlage wie der erste Eingangstakt CLK aufweist. Über die einstellbare dritte Verzögerungseinheit V3 kann nun bestimmt werden, ob das Taktsignal am zweiten Eingang IN2 der Schaltungseinheit S gegenüber dem zweiten Eingangstakt /CLK ebenfalls dieselbe Phasenlage (Verzögerungszeit der dritten Verzögerungseinheit V3 = 0) oder eine negative Phasenverschiebung (Verzögerungszeit der dritten Verzögerungseinheit V3 > 0) aufweist.

Figur 2 zeigt ein zweites Ausführungsbeispiel der integrierten Schaltung. Es unterscheidet sich vom Ausführungsbeispiel aus Figur 1 nur gemäß der im folgenden beschriebenen, zusätzlichen Komponenten. Der Ausgang der ersten Verzögerungseinheit V1 ist nicht direkt, sondern über eine einstellbare vierte Verzögerungseinheit V4 mit dem ersten Eingang IN1 der Schaltungseinheit S verbunden. Außerdem ist der Ausgang der vierten Verzögerungseinheit V4 und der erste Eingang IN1 der Schaltungseinheit S über eine fünfte Verzögerungseinheit V5 mit einstellbarer Verzögerungszeit mit dem Phasendetektor Δϕ verbunden. Außerdem ist der Eingang der ersten Verzögerungseinheit V1 nicht direkt, sondern über eine einstellbare sechste Verzögerungseinheit V6 mit dem Phasendetektor Δϕ verbunden. Die Einstellung der Verzögerungszeiten der vierten, fünften und sechsten Verzögerungseinheit V4, V5, V6 erfolgt über entsprechende Steuereingänge B, C, D, ebenso wie das oben beschriebene Einstellen der Verzögerungszeit der dritten Verzögerungseinheit V3.

Die zusätzlichen Verzögerungseinheiten V4, V5, V6 dienen einer größeren Flexibilität bei der Einstellung der Phasenlage der der Schaltungseinheit S zugeführten Taktsignale. Wird beispielsweise die Verzögerungszeit der fünften Verzögerungseinheit V5 auf einen positiven Wert eingestellt, während die Verzögerungszeit der sechsten Verzögerungseinheit V6 Null ist oder einen kleineren Wert annimmt, eilt die Phase des Taktsignals am ersten Eingang IN1 der Schaltungseinheit S der Phase des ersten Eingangstaktes CLK voraus, wenn der Phasendetektor Δϕ keine Phasendifferenz mehr detektiert. Ist dagegen die Verzögerungszeit der sechsten Verzögerungseinheit V6 größer als die Verzögerungszeit der fünften Verzögerungseinheit V5, eilt die Phase des Taktsignals am Eingang IN1 der Schaltungseinheit S der Phase des ersten Eingangstaktes CLK nach. Dies liegt daran, daß der Phasendetektor Δϕ immer die Phasendifferenz der Taktsignale an seinen Eingängen feststellt.

Da die Steuereinheit CTR die zweite Verzögerungseinheit V2 ebenso ansteuert, wie die erste Verzögerungseinheit V1, wirkt sich die Verzögerungszeit der fünften und sechsten Verzögerungseinheit V5, V6 auch auf die Phasenlage des Taktsignals am zweiten Eingang IN2 der Schaltungseinheit S aus.

Das dem ersten Eingang IN1 der Schaltungseinheit S zugeführte Taktsignal ist gegenüber dem ersten Eingangstakt CLK um die Summe der Verzögerungszeiten der ersten Verzögerungseinheit V1 und der vierten Verzögerungseinheit V4 verzögert. Wird nun die Verzögerungszeit der vierten Verzögerungseinheit V4 auf einen positiven Wert eingestellt, ergibt sich aufgrund der von der DLL durchgeführten Regelung eine kleinere Verzögerungszeit der ersten Verzögerungseinheit V1. Somit ist auch die mit dieser übereinstimmende Verzögerungszeit der zweiten Verzögerungseinheit V2 geringer, so daß durch Veränderung der Verzögerungszeit der vierten Verzögerungseinheit V4 auch Einfluß auf die Phasenlage des Taktsignals am zweiten Eingang IN2 der Schaltungseinheit S genommen wird.

Bei anderen Ausführungsbeispielen der Erfindung kann selbstverständlich auch nur eine oder zwei der drei zusätzlichen in Figur 2 dargestellten Verzögerungseinheiten V4, V5, V6 vorhanden sein.

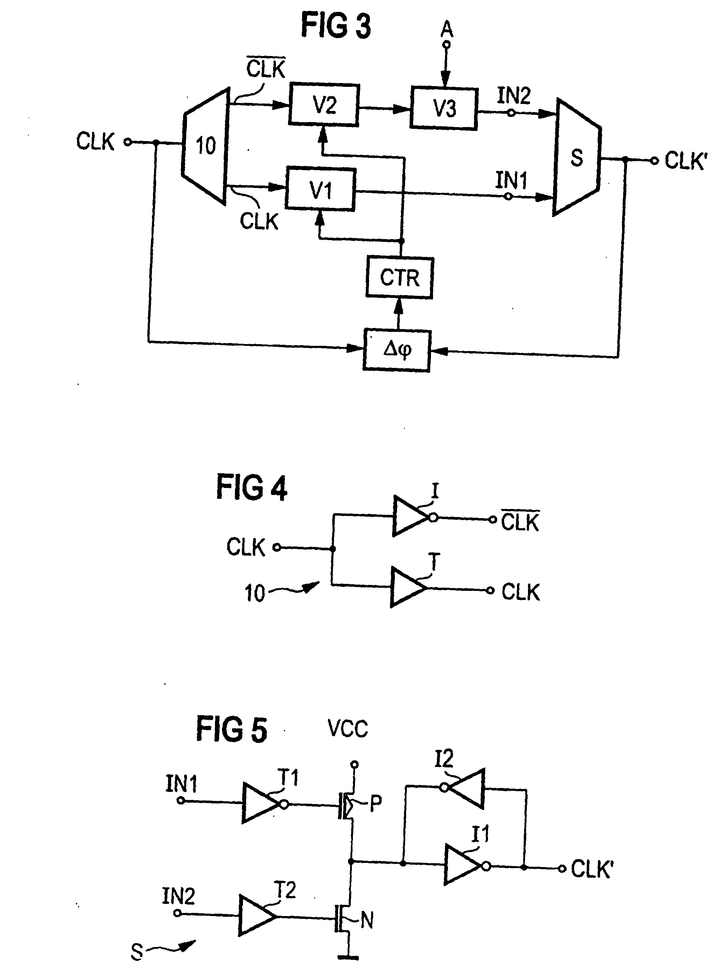

Figur 3 zeigt ein drittes Ausführungsbeispiel der Erfindung, das sich von demjenigen in Figur 1 nur in folgenden Punkten unterscheidet:

Zur Erzeugung des zweiten Taktsignals /CLK aus dem ersten Taktsignal CLK dient eine Eingangsschaltung 10. Ihr wird eingangsseitig das erste Taktsignal CLK zugeführt, das auch direkt dem ersten Eingang des Phasendetektors zugeführt wird. Die Eingangsschaltung erzeugt das zweite Taktsignal /CLK durch Invertierung des ersten Taktsignals CLK und verzögert das erste Taktsignal in einer Weise, daß an ihren Ausgängen die beiden Taktsignale genau 180° Phasenverschiebung zueinander aufweisen. Auf die Eingangsschaltung 10 wird weiter unten bezüglich Figur 4 noch eingegangen.

Die Schaltungseinheit S in Figur 3 ist zwischen dem Ausgang der ersten Verzögerungseinheit V1 und den zweiten Eingang des Phasendetektors Δϕ angeordnet. Sie erzeugt einen Ausgangstakt CLK', dessen Flanken in weiter unten bezüglich Figur 5 erläuterter Weise aus Flanken der Signale an ihren Eingängen IN1, IN2 abgeleitet werden.

Figur 4 zeigt ein Ausführungsbeispiel der Eingangsschaltung 10 aus Figur 3, mit der zwei zueinander inverse Taktsignale erzeugt werden. Sie weist einen invertierenden Treiber bzw. Inverter I und einen (nicht invertierenden) Treiber T auf, die jeweils die gleiche Schaltzeit aufweisen. Ihren Eingängen wird das nicht invertierte erste Taktsignal CLK zugeführt. Am Ausgang des Inverters I erzeugt dieser das zweite Taktsignal /CLK, das invertiert gegenüber dem ersten Taktsignal CLK ist. Der Treiber T gibt an seinem Ausgang das nicht invertierte erste Taktsignal CLK verzögert aus. Da die Schaltzeiten des Inverters I und des Treibers T übereinstimmen, sind das erste und das zweite Taktsignal genau um 180° gegeneinander phasenverschoben.

Figur 5 ist ein Ausführungsbeispiel der Schaltungseinheit S aus Figur 3 zu entnehmen. Zwischen einem positiven Versorgungspotential VCC und Masse ist eine Reihenschaltung eines p-Kanal-Transistor P und eines n-Kanal-Transistors N angeordnet. Der erste Eingang IN1 der Schaltungseinheit S ist über einen invertierenden Treiber T1 mit dem Gate des p-Kanal-Transistors P verbunden. Der zweite Eingang IN2 der Schaltungseinheit S ist über einen nicht-invertierenden Treiber T2 mit dem Gate des n-Kanal-Transistors N verbunden. Die Drains der beiden Transistoren P, N sind mit dem Eingang eines ersten Inverters I1 verbunden, der an seinem Ausgang den Ausgangstakt CLK' generiert. Der Ausgang des ersten Inverters I1 ist über einen zweiten Inverter I2 mit dem Eingang des ersten Inverters I1 verbunden. Die beiden Inverter I1, I2 bilden eine Halteschaltung.

Die in Figur 5 gezeigte Schaltungseinheit S generiert den Ausgangstakt CLK' mit positiven Flanken, die phasenstarr zu den positiven Flanken des Signals am ersten Eingang IN1 sind, und mit negativen Flanken, die phasenstarr zu den positiven Flanken des Signals am zweiten Eingang IN2 sind.

Der Phasendetektor Δϕ in Figur 3 erfaßt die Phasenabweichung zwischen der positiven Flanke des ersten Taktsignals CLK und der positiven Flanke des Ausgangstaktes CLK' der Schaltungseinheit S. Die Steuereinheit regelt diese Phasendifferenz über die erste Verzögerungseinheit V1 zu Null. Durch Einstellen der Verzögerungszeit der dritten Verzögerungseinheit V3 kann die Phasenlage des Signals am zweiten Eingang IN2 zur Phasenlage des Signals am ersten Eingang IN1 beeinflußt werden. Da das Signal am zweiten Eingang IN2 die Phasenlage der negativen Flanken des Ausgangstaktes CLK' beeinflußt und das Signal am ersten Eingang IN1 diejenige seiner positiven Flanken, läßt sich über die dritte Verzögerungseinheit vorteilhaft die Lage der negativen Flanken des Ausgangstaktes CLK' bezüglich seiner positiven Flanken einstellen.

## Patentansprüche

1. Integrierte Schaltung
- mit einer ersten Verzögerungseinheit (V1) mit einstellbarer Verzögerungszeit, die einen Eingang zur Zuführung eines ersten Taktsignals (CLK) aufweist,
- mit einer zweiten Verzögerungseinheit (V2) mit einstellbarer Verzögerungszeit, die einen Eingang zur Zuführung eines zweiten Taktsignals (/CLK) aufweist,
- mit einem Phasendetektor (Δϕ), dessen erster Eingang mit dem Eingang und dessen zweiter Eingang mit dem Ausgang der ersten Verzögerungseinheit (V1) verbunden ist,
- mit einer Schaltungseinheit (S) mit einem ersten Eingang (IN1), der mit dem Ausgang der ersten Verzögerungseinheit (V1) verbunden ist, und mit einem zweiten Eingang (IN2), der mit dem Ausgang der zweiten Verzögerungseinheit (V2) verbunden ist,
- mit einer Steuereinheit (CTR), die zur Ausregelung der vom Phasendetektor (Δϕ) festgestellten Phasendifferenz die Verzögerungszeit der ersten Verzögerungseinheit (V1) steuert und die die Verzögerungszeit der zweiten Verzögerungseinheit (V2) auf im wesentlichen den gleichen Wert wie diejenige der ersten Verzögerungseinheit (V1) einstellt,
**gekennzeichnet durch**
- eine dritte Verzögerungseinheit (V3) mit einstellbarer Verzögerungszeit, die unabhängig von der zweiten Verzögerungseinheit (V2) einstellbar ist, wobei über die dritte Verzögerungseinheit der Ausgang der zweiten Verzögerungseinheit (V2) mit dem zweiten Eingang (IN2) der Schaltungseinheit (S) verbunden ist.

2. Integrierte Schaltung nach Anspruch 1,
bei der das zweite Taktsignal (/CLK) invers zum ersten Taktsignal (CLK) ist.

3. Integrierte Schaltung nach Anspruch 1,
mit einer vierten Verzögerungseinheit (V4) mit einstellbarer Verzögerungszeit, über die der Ausgang der ersten Verzögerungseinheit (V1) sowohl mit dem zweiten Eingang des Phasendetektors (Δϕ) als auch mit dem ersten Eingang (IN1) der Schaltungseinheit (S) verbunden ist.

4. Integrierte Schaltung nach Anspruch 1,
mit einer fünften Verzögerungseinheit (V5) mit einstellbarer Verzögerungszeit, über die der Ausgang der ersten Verzögerungseinheit (V1) und der erste Eingang (IN1) der Schaltungseinheit (S) mit dem zweiten Eingang des Phasendetektors (Δϕ) verbunden ist.

5. Integrierte Schaltung nach Anspruch 1,
mit einer sechsten Verzögerungseinheit (V6) mit einstellbarer Verzögerungszeit, über die der Eingang der ersten Verzögerungseinheit (V1) mit dem ersten Eingang des Phasendetektors (Δϕ) verbunden ist.

6. Integrierte Schaltung nach Anspruch 2,
dessen Schaltungseinheit (S) an einem Ausgang einen Ausgangstakt (CLK') erzeugt, dessen eine Flankenart phasenstarr zu den positiven Flanken des Signals am ersten Eingang (IN1) ist und dessen zweite Flankenart phasenstarr zu den positiven Flanken des Signals am zweiten Eingang (IN2) ist,

7. Integrierte Schaltung nach Anspruch 6,
bei der der Ausgang der ersten Verzögerungseinheit (V1) über die Schaltungseinheit (S) mit dem zweiten Eingang des Phasendetektors (Δϕ) verbunden ist.

## Claims

1. Integrated circuit
- having a first delay unit (V1) with an adjustable delay time which has an input for supplying a first clock signal (CLK),
- having a second delay unit (V2) with an adjustable delay time which has an input for supplying a second clock signal (/CLK),
- having a phase detector (Δϕ) whose first input is connected to the input and whose second input is connected to the output of the first delay unit (V1),
- having a circuit unit (S) with a first input (IN1), which is connected to the output of the first delay unit (V1), and with a second input (IN2), which is connected to the output of the second delay unit (V2),
- having a control unit (CTR) which corrects the phase difference established by the phase detector (Δϕ) by controlling the delay time of the first delay unit (V1) and which adjusts the delay time of the second delay unit (V2) to essentially the same value as that for the first delay unit (V1), **characterized by**
- a third delay unit (V3) with an adjustable delay time which can be adjusted independently of the second delay unit (V2), the output of the second delay unit (V2) being connected to the second input (IN2) on the circuit unit (S) via the third delay unit.

2. Integrated circuit according to Claim 1,
in which the second clock signal (/CLK) is the inverse of the first clock signal (CLK).

3. Integrated circuit according to Claim 1,
having a fourth delay unit (V4) with an adjustable delay time via which the output of the first delay unit (V1) is connected both to the second input on the phase detector (Δϕ) and to the first input (IN1) on the circuit unit (S).

4. Integrated circuit according to Claim 1,
having a fifth delay unit (V5) with an adjustable delay time via which the output of the first delay unit (V1) and the first input (IN1) on the circuit unit (S) are connected to the second input on the phase detector (Δϕ).

5. Integrated circuit according to Claim 1,
having a sixth delay unit (V6) with an adjustable delay time via which the input on the first delay unit (V1) is connected to the first input on the phase detector (Δϕ).

6. Integrated circuit according to Claim 2,
whose circuit unit (S) produces, at an output, an output clock (CLK') whose first edge type is locked in phase to the positive edges of the signal at the first input (IN1) and whose second edge type is locked in phase to the positive edges of the signal at the second input (IN2).

7. Integrated circuit according to Claim 6,
in which the output of the first delay unit (V1) is connected to the second input of the phase detector (Δϕ) via the circuit unit (S).

## Revendications

1. Circuit intégré
- comprenant une première unité (V1) de retard à temps de retard réglable qui comporte une entrée pour l'entrée d'un premier signal (CLK) d'horloge,
- comprenant une deuxième unité (V2) de retard à durée de retard réglable qui comporte une entrée pour l'entrée d'un deuxième signal (/CLK) d'horloge,
- comprenant un détecteur (Δϕ) de phase dont la première entrée est reliée à l'entrée de la première unité (V1) de retard et dont la deuxième entrée est reliée à la sortie de la première unité (V1) de retard,
- comprenant une unité (S) de circuit ayant une première entrée (IN1) qui est reliée à la sortie de la première unité (V1) de retard et une deuxième entrée (IN2) qui est reliée à la sortie de la deuxième unité (V2) de retard,
- comprenant une unité (CTR) de commande qui, pour réguler la différence de phase constatée par le détecteur (Δϕ) de phase, commande la durée de retard de la première unité (V1) de retard et règle la durée de retard de la deuxième unité (V2) de retard sensiblement sur la même valeur que celle de la première unité (V1) de retard,
**caractérisé par**
- une troisième unité (V3) de retard à durée de retard réglable qui est réglable indépendamment de la deuxième unité (V2) de retard, la sortie de la deuxième unité (V2) de retard étant reliée à la deuxième entrée (IN2) de l'unité (S) de circuit par la troisième unité de retard.

2. Circuit intégré suivant la revendication 1,
dans lequel le deuxième signal (/CLK) d'horloge est inversé par rapport au premier signal (CLK) d'horloge.

3. Circuit intégré suivant la revendication 1,
comprenant une quatrième unité (V4) de retard à durée de retard réglable, par laquelle la sortie de la première unité (V1) de retard est reliée tant à la deuxième entrée du détecteur (Δϕ) de phase qu'à la première entrée (IN1) de l'unité (S) de circuit.

4. Circuit intégré suivant la revendication 1,
comprenant une cinquième unité (V5) de retard à durée de retard réglable, par laquelle la sortie de la première unité (V1) de retard et la première entrée (IN1) de l'unité (S) de circuit sont reliées à la deuxième entrée du détecteur (Δϕ) de phase.

5. Circuit intégré suivant la revendication 1,
comprenant une sixième unité (V6) de retard à durée de retard réglable, par laquelle l'entrée de la première unité (V1) de retard est reliée à la première entrée du détecteur (Δϕ) de phase.

6. Circuit intégré suivant la revendication 2,
dont l'unité (S) de circuit produit à une sortie une cadence (CLK') de sortie dont un type de flanc est verrouillé en phase par rapport au flanc positif du signal sur la première entrée (IN1) et dont le deuxième type de flanc est verrouillé en phase par rapport au flanc positif du signal sur la deuxième entrée (IN2).

7. Circuit intégré suivant la revendication 6,
dans lequel la sortie de la première unité (V1) de retard est reliée à la deuxième entrée du détecteur (Δϕ) de phase par l'unité (S) de circuit.
